# EUROPEAN PATENT SPECIFICATION

(11) **EP 3 566 066 B1**
(45) Date of publication and mention of the grant of the patent: **25.08.2021**
(21) Application number: 18700255.5
(22) Date of filing: 05.01.2018
(51) Int. Cl.: G01R 33/32, G01R 33/30, G01N 24/10, G01R 33/60

(54) **INSTANTANEOUS MAGNETIC RESONANCE SPECTROSCOPY OF A SAMPLE**
INSTANTANE MAGNETRESONANZSPEKTROSKOPIE EINER PROBE
SPECTROSCOPIE PAR RÉSONANCE MAGNÉTIQUE INSTANTANÉE D'UN ÉCHANTILLON

(30) Priority: 06.01.2017 NL 2018137
(43) Date of publication of application: 13.11.2019
(73) Proprietor: Rijksuniversiteit Groningen, 9712 CP Groningen (NL); Academisch Ziekenhuis Groningen, 9713 GZ Groningen (NL)
(72) Inventor: CHIPAUX, Mayeul Sylvain, 9713 AV Groningen (NL); SCHIRHAGL, Romana, 9713 AV Groningen (NL)
(74) Representative: V.O.
(86) International application number: PCT/NL2018/050007
(87) International publication number: WO 2018/128543

(56) References cited:
- WO-A1-2015/178883
- GB-A- 2 483 767
- JP-A- H0 371 048
- US-B1- 8 593 141

## Description

### TECHNICAL FIELD AND BACKGROUND

The present invention relates to a method and system for magnetic resonance spectroscopy.

As background, GB 2 483 767 A describes a microfluidic cell with a diamond sensor comprising a quantum spin defect.

Electron Spin resonance (ESR) and Nuclear Magnetic Resonance (NMR) spectroscopies are powerful tools to detect and characterize magnetic molecules by their electron or nuclear spin. For example, molecules in a sample of interest can be detected and characterized by detecting their magnetic or electronic resonance. Typically, a magnetic field is applied to the sample combined with a radio-frequency signal. A full resonance spectrum of the energy or frequency absorbed by the sample can be measured by varying the magnetic field and/or radiofrequency signal in time.

Unfortunately, in standard magnetic spectroscopy, the sensitivity of the detection (i.e. the minimum amount of molecule that is required for the measurement) is limited by the low energy of the spin transition to be detected. Typically a minimum of thousand molecules is required to perform NMR or ESR spectroscopy. Furthermore obtaining a full magnetic resonance spectrum requires a temporal sweep that takes a relatively long time. Furthermore, standard measurements require a strong magnetic field on large areas. This is e.g. provided by a superconductor magnet, which makes ESR and NMR spectrometers quite expensive.

It is desired to address these or other problems in an improved method and system for measuring the magnetic resonance spectrum of a sample.

### SUMMARY

One aspect of the present invention provides a method for measuring a magnetic resonance spectrum of a sample in accordance with claim 1. The sample to be measured is provided in proximity to a sensor array. The sensor array comprises a plurality of magnetic resonance sensors distributed along a predetermined coordinate of the sensor array. A magnetic field gradient is applied over the sample. The direction of the gradient is such that the magnetic field varies over different regions of the sample as a function of a respective position of each sample region along the coordinate of the sensor array. Sensor signals of the magnetic resonance sensors are then recorded in the presence of the magnetic field gradient as a function of the coordinate to determine the magnetic resonance spectrum.

By applying a magnetic field gradient over the sample along a coordinate of the sensor array, different sensors can simultaneously measure the effect of different magnetic fields on the magnetic resonances in the sample. The simultaneous sensor signals can be distinguished along the coordinate and related to the magnetic field at that coordinate to reconstruct the magnetic spectrum. In this way an instantaneous magnetic spectrum can be obtained without having to sweep the magnetic field in time.

Another or further aspect of the present invention provides a system for measuring a magnetic resonance spectrum of a sample, as defined in claim 14. The system comprises a sensor array. The sensor array comprises a plurality of magnetic resonance sensors distributed along a predetermined coordinate of the sensor array. A sample cell is configured to provide the sample to be measured in proximity to the sensor array, e.g. forming an interface with the sample or being suspended as particles throughout the sample. A magnet is configured to apply a magnetic field gradient over the sample such that magnetic field in use varies over different regions of the sample as a function of a respective position of each sample region along the coordinate of the sensor array. A measurement device is configured to record, in the presence of the magnetic field gradient, sensor signals, which are dependent on nearby magnetic resonance of the sample and correspond to respective parts of the magnetic resonance spectrum, of the magnetic resonance sensors as a function of the coordinate to determine the magnetic resonance spectrum.

### BRIEF DESCRIPTION OF DRAWINGS

These and other features, aspects, and advantages of the apparatus, systems and methods of the present disclosure will become better understood from the following description, appended claims, and accompanying drawing wherein:
FIG 1A schematically illustrates an embodiment of a system for measuring a magnetic resonance spectrum of a sample;
FIG 1B schematically illustrates a close-up of sample regions interacting with respective sensors across a sensor interface;
FIG 2 schematically illustrates energy levels of a sensor NV (top) and corresponding sample region S (bottom);
FIGs 3A-3C schematically illustrate an embodiment for calculating the magnetic resonance spectrum M;
FIG 4A schematically illustrates an energy level diagram for a colour center;
FIG 4B illustrates an example of an average electron-spin state occupancy during a spin relaxation measurement;
FIGs 5A and 5B schematically illustrate embodiments for creating a magnetic field gradient;
FIG 6A and 6B schematically illustrate a cross-section and perspective view of one embodiment of a sample cell;
FIGs 7A-7C schematically illustrate an example for applying a second gradient to the sample itself;
FIGs 8A and 8B illustrate another embodiment with sensors embedded in the sample.

### DESCRIPTION OF EMBODIMENTS

The invention is described more fully hereinafter with reference to the accompanying drawings, in which embodiments of the invention are shown. Embodiments may be described with reference to schematic and/or cross-section illustrations of possibly idealized embodiments and intermediate structures of the invention. In the description and drawings, like numbers refer to like elements throughout. Relative terms as well as derivatives thereof should be construed to refer to the orientation as then described or as shown in the drawing under discussion. These relative terms are for convenience of description and do not require that the system be constructed or operated in a particular orientation unless stated otherwise. As used herein, the singular forms "a", "an" and "the" are intended to include the plural forms as well, unless the context clearly indicates otherwise. The term "and/or" includes any and all combinations of one or more of the associated listed items. It will be understood that the terms "comprises" and/or "comprising" specify the presence of stated features but do not preclude the presence or addition of one or more other features. It will be further understood that when a particular step of a method is referred to as subsequent to another step, it can directly follow said other step or one or more intermediate steps may be carried out before carrying out the particular step, unless specified otherwise. Likewise it will be understood that when a connection between structures or components is described, this connection may be established directly or through intermediate structures or components unless specified otherwise.

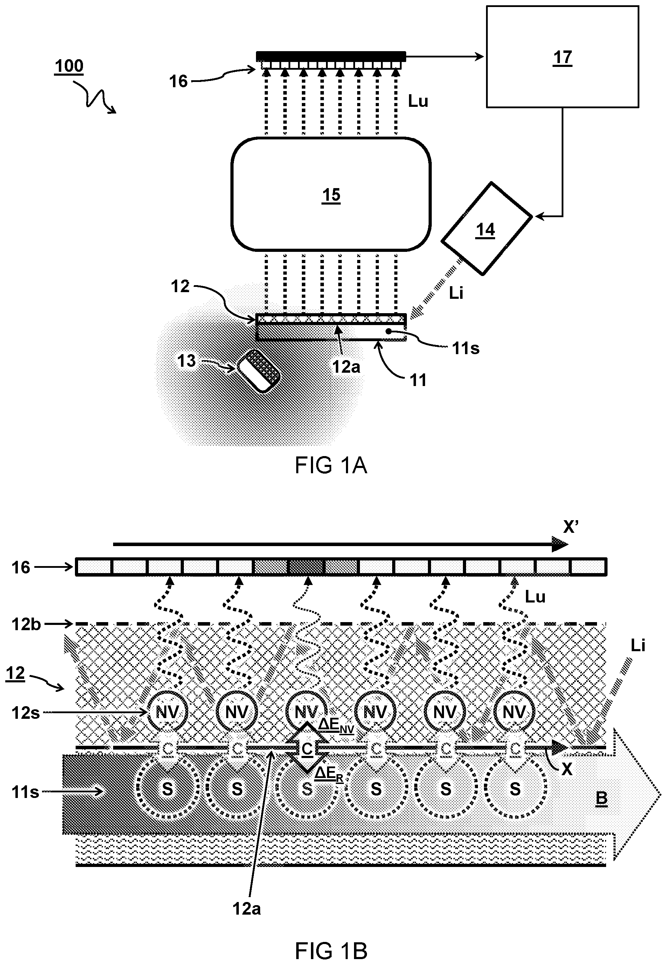

FIG 1A schematically illustrates an embodiment of a system 100 for measuring a magnetic resonance spectrum M of a sample 11s. FIG 1B schematically illustrates a close-up of sample regions S interacting with respective magnetic resonance sensors 12s across the sensor interface 12a.

In a preferred embodiment, the sample 11s to be measured is brought in proximity to, e.g. contacted with, a sensor array 12. The sensor array 12 comprises a plurality of magnetic resonance sensors 12s distributed along a predefined coordinate or direction X of the sensor array 12. A magnetic field gradient is applied over the sample 11s such that the magnetic field B varies over different regions S of the sample 11s as a function of a respective position of each sample region S along the coordinate X. Sensor signals Lu of the magnetic resonance sensors 12s may thus be recorded as a function of the coordinate X to determine the magnetic resonance spectrum M.

In the embodiment shown, the sample 11s to be measured is provided in contact with a sensor interface 12a. The sensor array 12 comprises a plurality of magnetic resonance sensors 12s distributed along at least one surface coordinate X of the sensor interface 12a. As described herein, the sensor interface 12a typically refers to a physical boundary, e.g. of a material forming the sensor array 12. For example, the system 100 as shown comprises a sensor array 12 with a sensor interface 12a forming a boundary between the sensors 12s and the sample regions S. In some embodiments, the sensors 12s are distributed inside a material forming the sensor array 12 at another side of the sensor interface 12a from the sample 11s. A sample cell 11 is configured to provide the sample 11s to be measured in proximity, e.g. contact with the sensor interface 12a.

According to the invention, a magnetic field gradient is applied over the sample 11s such that the magnetic field B varies over different regions S of the sample 11s as a function of a respective position of each sample region S along the aforementioned surface coordinate X of the sensor interface 12a. For example, the system comprises one or more permanent magnets 13 to apply the magnetic field gradient over the sample 11s. Alternatively, or in addition, one or more electromagnets can be used (not shown).

It will be appreciated that an energy (difference) ΔE_{R}, or equivalently the resonance frequency, associated with a magnetic resonance R of the sample 11s at a specific value of the magnetic field B can be characteristic for a magnetic moment of constituents forming the sample 11s. For example a nuclear magnetic moment or electron (para)magnetic moment of molecules/atoms in the sample may have an energy depending on the local magnitude (and direction) of the magnetic field. Typically a frequency of the magnetic resonance R of the sample 11s varies proportional to an amplitude of the magnetic field B in the sample 11s. For example, the resonance associated with an energy difference between up and down spin states may be proportional to a product of the magnetic field and a magnetic moment of the constituents, e.g. electron and/or nuclear spin.

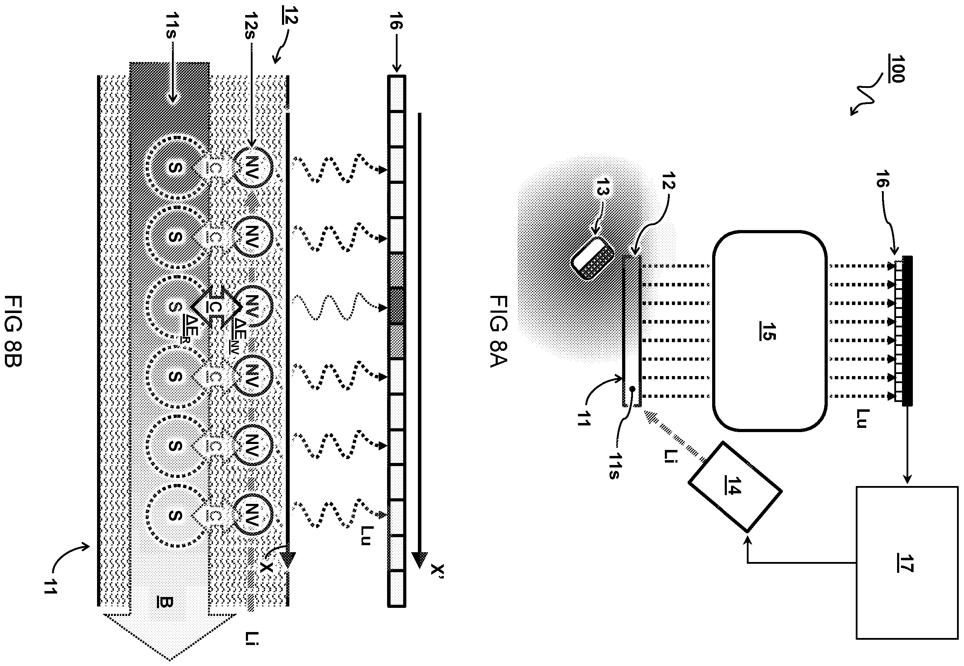

In a preferred embodiment, as described herein, the sensors 12s are formed by Nitrogen-Vacancy colour centers, which will be denoted throughout the figures and description as "NV". However, it will be appreciated that the principles of the present disclosure are not limited to NV colour centers. For example, other types of colour centers or point defects may be used such as silicon-vacancy centers (Si-V) in Diamond or Carbon antisite-vacancy pairs (C_{Si}V_{C}) in Silicon Carbide. Besides colour centers also other types of microscopic structures may provide similar results. Accordingly the notation "NV", e.g. with reference to any particular sensor NV, its (relative) energies E_{NV}, and magnetic field B_{NV} thereat, may be exchanged to apply to any magnetic sensor. Furthermore, while one preferred embodiment comprises a solid array of sensors 12s, e.g. as formed by NV centers in a diamond lattice, also other embodiments can be envisaged, e.g. with a sample comprising embedded or suspended sensors as described below with reference to FIG 8.

Preferably, the magnetic sensors are relatively small and in close proximity to one another to measure an appreciable spectrum. For example, a cross-section size per sensor is preferably less than hundred micrometer, less than one micrometer, less than ten nanometer, or even less. Also a spacing between the sensors is preferably less than hundred micrometer, less than one micrometer, less than ten nanometer, or even less, e.g. no spacing there between. In a preferred embodiment, the magnetic sensors thus have microscopic dimensions. For example, the microscopic magnetic sensors may have a cross-section size between one and hundred nanometer, e.g. less than one nanometer for a typical Nitrogen-Vacancy colour center. A measurement range or volume of the microscopic magnetic sensors may be provided by their size and/or extend somewhat around the sensor cross-section e.g. between one and ten nanometer around. A density of the microscopic sensors may vary. For example, a volume density up to 10¹⁸ microscopic sensors per cm³, or more. For example, a surface density up to 10¹⁴ per cm², or more. For densities above 10⁹ or 10¹⁰ per cm² it may be difficult to optically distinguish ensembles of sensors, but still more sensors may provide more signal. It will be appreciated that the smaller the size and/or range of the magnetic sensors, the more different field strengths can be measured per unit of length or volume and the more sensors can be packed into a given volume.

Alternatively to microscopic structures such as NV centers, also other types sensor devices can be envisaged. In principle, any type of sensor which can output a recordable signal as a function of a magnetic resonance in a nearby sample region can be used. For example, the sensor signal may depend on a local coupling of the sensor with its respective nearby sample region. For example, the magnetic resonance sensors may comprise transducers producing electrical signals as a function of a magnetic resonance in the nearby sample region. For example, measurement of the sensor signals may comprises recording electrical signals from an array of sensors, e.g. wherein the surface coordinate of the sensor interface extends along at least one measurement direction aligned with a projection of the surface coordinate. Examples of such sensors may e.g. include a SQUID array (superconducting quantum interference device) with a magnetic field gradient applied over the array. Other sensors may include an array of GMR (Giant MagnetoResistance) sensors or an array of Hall effect probes.

In one embodiment, each respective sensor 12s of the sensor array 12 is configured to provide a sensor signal Lu as a function of a coupling C between a volume S of the sample and the sensors. In the embodiment shown the sensor signal Lu is provided as a function of the coupling C across the sensor interface 12a. For example, such coupling C may depend on an energy matching ΔE_{NV}=ΔE_{R} between a magnetic resonance of a respective sensor 12s and a magnetic resonance of a respective sample region S of the sample 11s at the coordinate X. Typically, a strength of the coupling C or likelihood of interaction between the sensor 12s and the sample region S may depend on an energy ΔE_{R} or frequency of the magnetic resonance of the sample region S matching the energy ΔE_{NV} of the magnetic resonance of the sensor 12s.

According to the invention, sensor signals Lu of the magnetic resonance sensors 12s are recorded as a function of the coordinate X to determine the magnetic resonance spectrum M. For example, the system comprises a measurement device 16 configured to record the sensor signals Lu. For example, the signals are recorded on a storage medium of a controller 17, operatively connected to the measurement device 16.

In one embodiment, the sensor signals Lu comprise light, wherein the magnetic resonance sensors 12s comprise transducers producing the light as a function of a magnetic resonance in the nearby sample region S. In another or further embodiment, an amount of light or chance for emitting light depends on the local coupling C of the sensor 12s with its respective nearby sample region S. For example, the magnetic resonance sensors 12s exhibit a luminescence that is dependent on nearby magnetic resonances.

In one embodiment, the sensor signals Lu comprise light emitted by the sensors, e.g. a photoluminescent signal emitted by the sensors 12s. In the embodiment shown, the system comprises a light source 14 for sending light pulses Li to the sensor array 12. For example, the light pulses Li may trigger initialization and/or readout of the magnetic resonance sensors 12s. In one embodiment, the magnetic resonance sensors 12s are prepared in an initial state by a first light pulse Li, allowed some time to interact with the sample region S, and triggered by a second light pulse to emit a photoluminescent signal Lu that is indicative of the interaction. In some embodiments a controller 17 is configured to control the light source 14, e.g. to use predefined timing of the light pulses Li and/our readout of signals Lu. For example, signals from the measurement device 16 are gated to measure the signal Lu at a specific time interval, e.g. following the second pulse Li.

In a preferred embodiment, measurement of the sensor signals Lu comprises imaging light emitted from the sensor interface 12a. In the embodiment shown, the measurement device 16 comprises an array of light sensors to image light signals Lu from the magnetic resonance sensors 12s. In some embodiments, the system comprises a projection system 15 for imaging light signals Lu from the magnetic resonance sensors 12s. Typically the projection system 15 comprises a system of lenses and/or mirrors to project an image of a light pattern emitted by the magnetic resonance sensors 12s onto an array of light sensitive pixels 16. For example, the projection system 15 comprises a microscope. Optionally, the projection system 15 comprises a filter to filter out the light pulses Li of the light source 14 while passing the luminescent light signals Lu of the magnetic resonance sensors 12s.

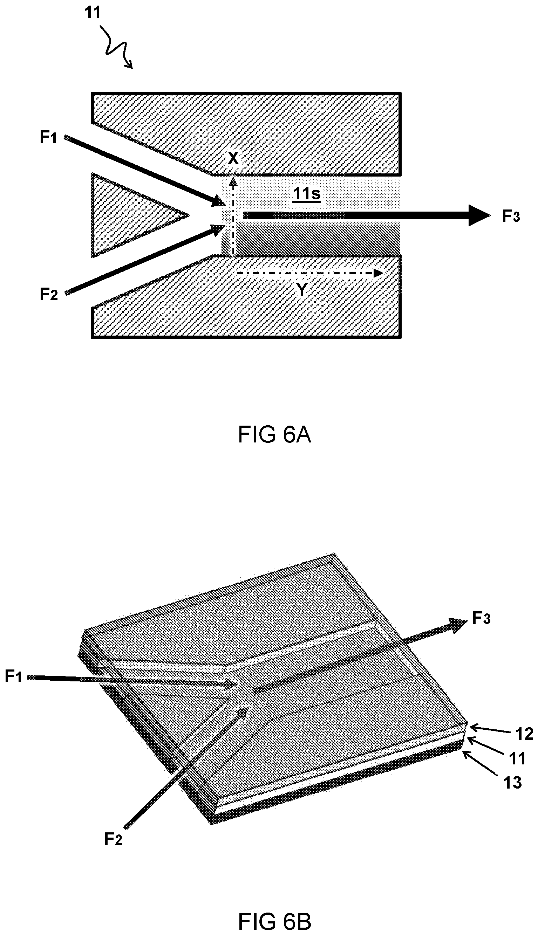

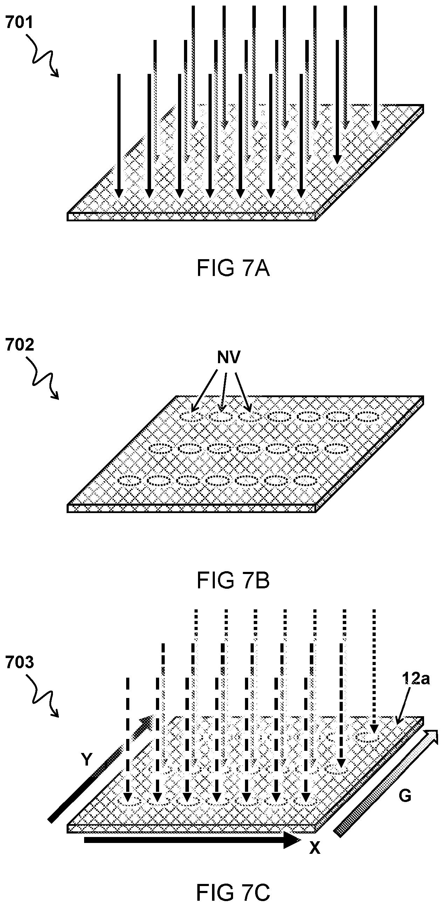

Advantageously, the projection system 15 may be configured to map the coordinate X of the sensor array onto different sensor element arranged along a corresponding coordinate X' of the measurement device 16, e.g. pixels of a light sensitive chip or camera. In one embodiment, the measurement device 16 comprises a pixel array with light sensitive pixels extending along at least one measurement direction aligned with a projection of the coordinate X. In some embodiments, the measurement device 16 comprises a two-dimensional array of measurement pixels wherein one direction is aligned with the projection of the coordinate X, e.g. along the surface of the interface 12a, and another direction Y (not shown here) is aligned with some other variation, e.g. in the sample 11s as will be discussed later with reference to FIGs 6 and 7.

As described herein, the sample 11s is distinct from the sensor array 12. In one embodiment, the sample 11s is held against the sensor interface 12a or the sample 11s, e.g. by sample cell 11. For example a wall of the sample cell forms the sensor interface 12a. In some embodiments, the sample 11s is fluid, e.g. liquid or gaseous. In other or further embodiments, the sample 11s is flowed past the sensor interface 12a. Alternatively, the sample 11s may be applied to a surface of the sensor interface 12a. In some embodiments, solid samples may be used, e.g. pushed against the sensor interface 12a.

In the embodiment shown, the light Li is injected from a side of the sensor array 12, e.g. traversing a block of material while exciting the magnetic resonance sensors 12s, e.g. at the sensor interface 12a. For example, the light Li may bounce one or more times between the interfaces 12a, 12b, e.g. under a condition of partial or total internal reflection. Also other ways for pumping the magnetic resonance sensors 12s van be envisaged, e.g. from top or bottom, optionally combined with dichroic mirrors or light filters to pass only the resulting luminescent light Lu to a detector.

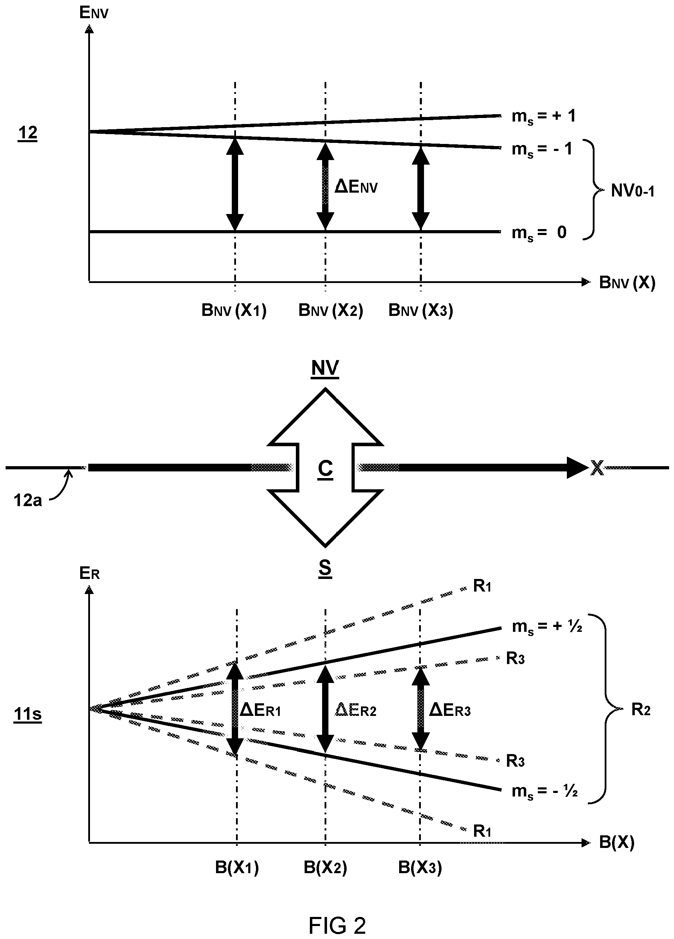

FIG 2 schematically illustrates energy levels of the sensor, in this case NV (top), and sample region S (bottom).

In one embodiment, the variation of the magnetic field B in the sample 11s causes a corresponding variation of resonance energies ΔE_{R1}, ΔE_{R2}, ΔE_{R13} associated with one or more magnetic resonances R₁,R₂,R₃ in the sample 11s as a function of the respective position of each sample region S along the coordinate X, e.g. the surface coordinate of the sensor interface 12a or other predefined coordinate of the sensor array and/or sample. Accordingly, it may occur that a respective sample region S within range of a respective sensor NV at a specific coordinate X₂ matches in energy ΔE_{NV}=ΔE_{R2} with a corresponding magnetic resonance NV₀₋₁ of the respective sensor NV across the sensor interface 12a. This resonance can e.g. be detected when energy can be transferred between the sensor NV and the sample region S. For example, when the sensor NV is predominantly initialized in the mₛ=0 state, the sensor may couple to one of the energy matching resonances in the sample region S to facilitate switching to the mₛ=-1 (or +1) state.

In one embodiment, positions X1, X2, X3 along the coordinate X are associated with respective values B1, B2, B3 proportional to an amplitude of the magnetic field B at those positions. In another or further embodiment, respective amplitudes of the magnetic field B or values proportional thereto can be stored in a lookup-table or parametrized in a function for each measurement position along the coordinate X. In this way, resonances measured along the coordinate X can be related to specific values of the magnetic field B.

In some embodiments, an energy ΔE_{NV} of the magnetic resonance NV₀₋₁ of the sensor NV is dependent on any magnetic field B_{NV} which may permeate the sensor interface 12a. For example, an energy ΔE_{NV} of the magnetic resonance NV₀₋₁ of the sensor NV decreases proportional to an amplitude of the magnetic field B_{NV} at the sensor NV. It will be appreciated that when the energy difference ΔE_{NV} of the magnetic resonance sensors NV decreases with increasing magnetic fields B while the energy differences ΔE_{R} increases, this may effectively cause a scaling of the expected correspondence between the coordinate X and the magnetic field B. In this way the amplitude of the magnetic field required to measure a particular resonance can be decreased.

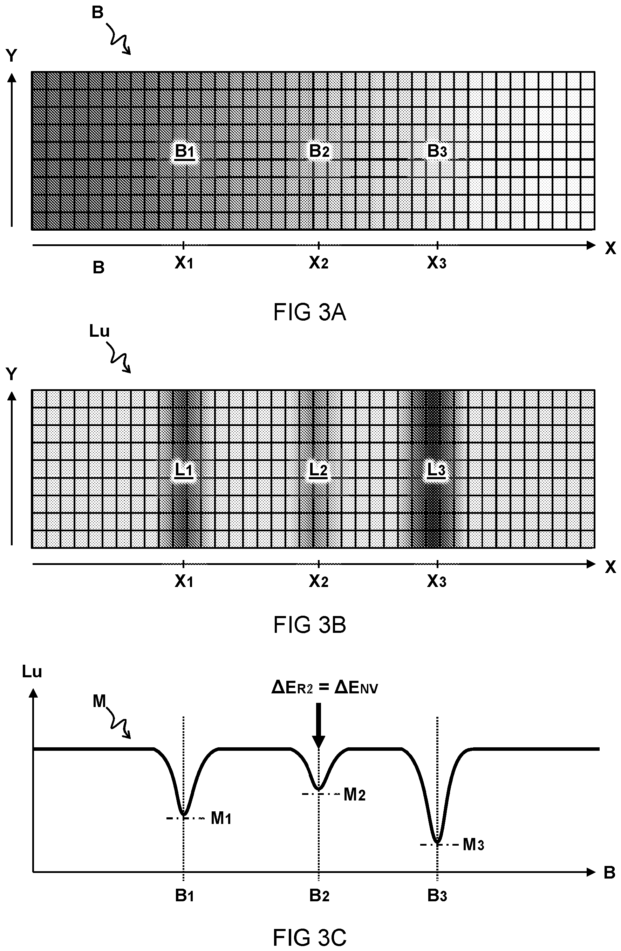

FIGs 3A-3C schematically illustrate an embodiment for calculating the magnetic resonance spectrum M. FIG 3A schematically shows an amplitude or strength of the magnetic field B by grayscale as a function of the coordinates X,Y. FIG 3B schematically shows an amplitude of the measured signals Lu by grayscale as a function of the coordinates X,Y. FIG 3C schematically shows an amplitude of the measured signals Lu as a function of the amplitude of the magnetic field B.

In one embodiment, the magnetic resonance spectrum M of the sample is calculated based on the sensor signals Lu as a function of the surface coordinate X. For example, an amplitude or strength of the magnetic field B varies as a function of the surface coordinate X. In one embodiment, amplitudes B1,B2,B3 of the magnetic field can be determined as a function of one or more coordinates X,Y. For example, the correspondence between the magnetic field and the coordinates can be determined by measurement, e.g. even using the sensors themselves. For example, the correspondence can be determined using a calibration sample with one or more known resonances. In some embodiments, the correspondence is determined by calculation, e.g. simulation of the magnetic field.

In one embodiment, amplitudes M1,M2,M3 of the magnetic resonance spectrum M are calculated based on amplitudes L1,L2,L3 of the measured sensor signals Lu for different positions X1,X2,X3 along the surface coordinate X based on corresponding values B 1,B2,B3 of the magnetic field B at those positions. For example, a magnetic resonance R₂ of the sample 11s is detected by its energy ΔE_{R2} matching the energy ΔE_{NV} of the sensor NV for a specific value B₂ of the magnetic field B resulting in a corresponding sensor signal L₂ at a specific surface coordinate X₂ associated with that specific value B₂ of the magnetic field B. For example, the measurement may provide nuclear magnetic resonance NMR spectrum and/or electron paramagnetic resonance EPR spectrum.

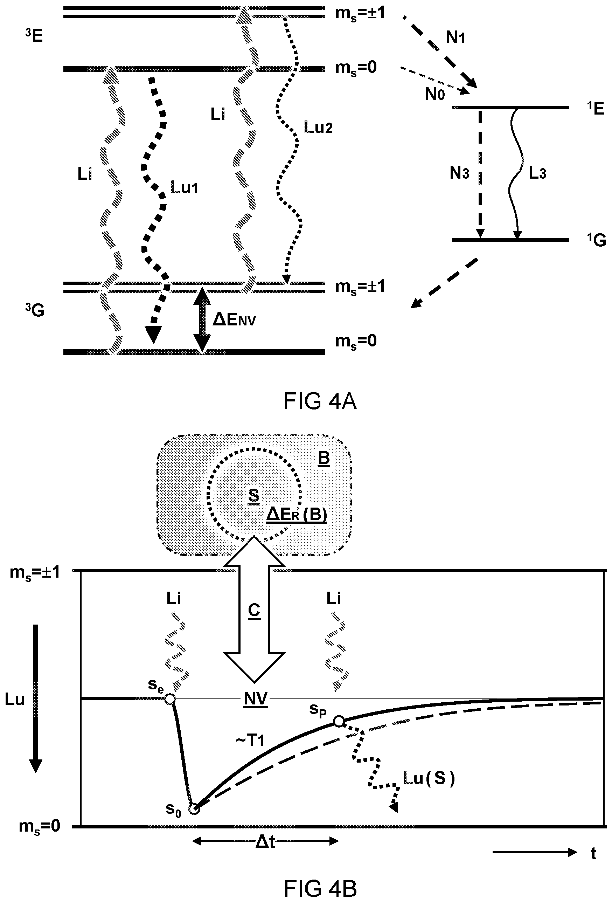

FIG 4A schematically illustrates an energy level diagram for a colour center, e.g. the Nitrogen-Vacancy colour center NV.

Energy levels indicated with the letter "G" refer to the colour center in the electronic ground state. Energy levels indicated with the letter "E" refer to the colour center in the electronic excited state. The numbers "3" in ³G and ³E and "1" in ¹G and ¹E represent the number of allowable spin states "mₛ", i.e. spin multiplicity. This may range from -S to S for a total of 2S+1 possible states. For example, in a triplet state where S = 1, mₛ can be -1, 0, or 1. The energy difference ΔE_{NV} between the mₛ=0 and mₛ=±1 states typically corresponds to the microwave region. Accordingly this may couple to magnetic resonances in the sample region S having a matching energy ΔE_{R} depending on the magnetic field B. The coupling may thus affect the relative population of those levels, thereby affecting the luminescence intensity L. This is one of the mechanisms by which magnetic resonances in the sample region S can be detected.

Transitions between the (electronic) ground triplet state ³G and (electronic) excited triplet state ³E may be effected by absorption of photons, in the present case by excitation with a first light beam Li. Decay of the electronic excited state ³E can produce a photon which is measured as luminescence Lui or Lu₂. Alternatively, the excited state may decay also to the excited singlet state ¹E via non-radiative transitions N₀ or N₁, depending on the spin-state mₛ. The excited singlet state ¹E may decay to the ground singlet state ¹G via non-radiative decay path N₃. The singlet decay may also producing luminescence L₃, but at another, relatively high, wavelength (low energy). The ground singlet state ¹G may non-radiatively convert back to the ground triplet state ³G.

Preferably, a likelihood of a radiative versus non-radiative decay depends on the electron-spin mₛ of the colour center. For example, in the case of the Nitrogen-Vacancy colour center, a likelihood of radiative decay Lui for an electron-spin mₛ=0 is higher than radiative decay Lu₂ for an electron-spin mₛ=±1. Conversely, the likelihood of non-radiative decay N₀ for electron-spin ms=0 is lower than non-radiative decay N₁ an electron-spin mₛ=±1. The total amount of luminescence Lu=Lu₁+Lu₂ depends on the likelihood of the radiative decay, which is higher when the colour center is in the ms=0 state. Also, due to the different decay paths, the colour center is more likely to be in the mₛ=0 state after excitation, which is one way to initialize the colour center to a known state.

FIG 4B illustrates an example of an average electron-spin state occupancy during different steps of some of the methods as described herein. In a quantum system the spin state is measured in one of discrete eigenstates. The present diagram may thus illustrate the chance of measuring one or the other state, e.g. determined by repeated measurements and/or measuring an ensemble of colour centers.

The average occupancy of the electron-spin may start at an equilibrium value mₛ="sₑ", e.g. determined according to a Boltzmann distribution depending on the energy of the different states. In one embodiment, the initial state mₛ=s₀ is set by the first light beam Li (pump) coinciding colour center. This may cause a transition of the colour center to an electronic excited state ³E, which -after decay- predominantly leaves the colour center in one of specific spin states, e.g. mₛ=0. This initialized spin state mₛ=s₀ may evolve according to a progression which may be influenced by the presence of a nearby resonance of the sample region S during a time period "Δt". After this time, the spin-state may have progressed to a state mₛ=sₚ. The progressed spin state "sₚ" may be read out using a second light beam Li (probe) which is directed to coincide with the colour center. This may produce luminescence light Lu. The amount of luminescence Lu may be a function of the electron-spin (mₛ) which may be dependent on the progression of the electron-spin mₛ="sₚ", which may be dependent on the resonance energy ΔE_{R} of the sample region S, which may be dependent on the magnetic field B.

In one embodiment, a relaxation time T₁ of the magnetic resonance sensors NV is measured. For example, the relaxation time T₁ of a respective sensor NV is dependent on a coupling between the sensor and a respective sample region S. In some embodiments, the relaxation time T₁ decreases for increased coupling C when the energy ΔE_{R} of the sample region S matches an energy ΔE_{NV} of the sensor NV

In one embodiment, the sensors NV are given a predefined time Δt to couple or interact with a resonance of a respective sample regions S under the influence of the specific magnetic field B dependent on the position of the sample region S and sensor along the surface coordinate X. For example, the magnetic resonance sensors NV are pumped by a first light beam Li from an equilibrium state sₑ to an initial state so, wherein the sensors decay back to equilibrium state sₑ according to a relaxation time T₁.

In some embodiments (not shown), an additional magnetic field is produced e.g. by an antenna. For example, the antenna can produce the additional magnetic field at a modulation frequency matching an energy difference between electron-spin states mₛ of the colour center for manipulating a progression of the electron-spin by facilitating a transition between the electron-spin states. For example, the measured luminescence is enhanced or suppressed depending on whether the modulation frequency of the electron beam matches the energy difference between the electron-spin states mₛ. For example the spin can be configured to be sensitive to a particular external resonance. Alternatively, or in addition, the magnetic field modulation can also be used to manipulate the spin of the sample.In other or further embodiments (not shown), the state of the electron-spin mₛ is manipulated after initialization to obtain a quantum superposition of at least two electron-spin states mₛ=0; mₛ=±1. For example, a probability of measuring a specific electron-spin state is dependent on a relative phase of wave functions in the quantum superposition. Accordingly, a progression of the relative phase may be dependent on a relative energy of the electron-spin states and/or the relative energy of the electron-spin states is dependent on the magnetic field B. In one embodiment, a probability of measuring a specific electron-spin state is dependent on a coherence of wave functions in the quantum superposition. For example, a coherence of the quantum superposition is dependent on the magnetic field B.

In one embodiment, a first racliofrequency field "RF1" (not shown) is added to coherently manipulate the spin of the NV center, e.g. creating a quantum superposition. Then it is not the T₁ of the NV center, but its T₂ which can be more sensitive. In some embodiment all the frequencies could be sent at the same time, e.g. one signal RF1 with several frequencies, or several RF1 with one frequencies. In another or further embodiment, a second radiofrequency field "RF2" (not shown) is added. For example, RF2 may match the resonance of the sample (and not the NV center), e.g. the signal RF2 may have only one frequency. In some cases these two radiofrequency signals are synchronized, to make the NV center sensitive to the region of the sample that are affected by RF2. In this case, in regions where the condition ΔE_{R}=frequency of RF2 matches, the coupling C may be higher thus locally affecting the signal Lu. This is DEER for double electron-electron resonance.

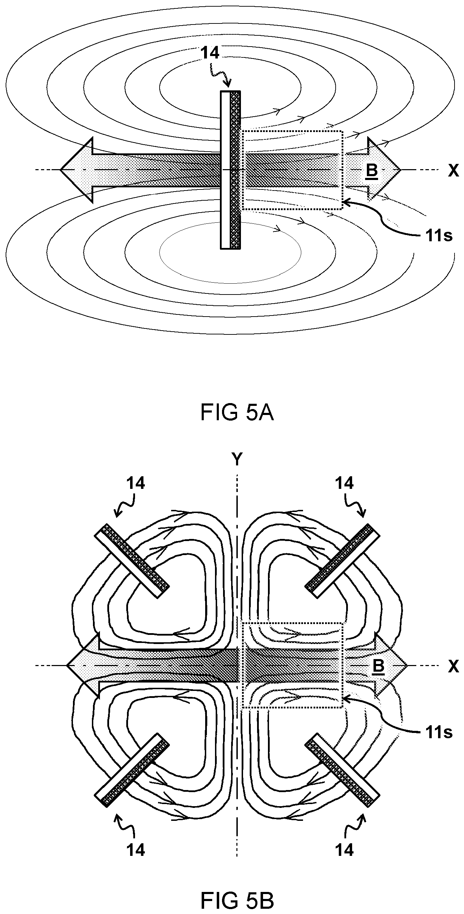

FIG 5A schematically illustrates one embodiment wherein a magnet 14 is placed at one side of the sample 11s to provide a decreasing magnetic field B there through as a function of the surface coordinate X.

FIG 5B schematically illustrates another embodiment wherein the sample 11s is placed in the magnetic field B provided by an arrangement of magnets 14.

In a preferred embodiment, an amplitude of the magnetic field varies monotonically over the sample 11s. This allows a relatively straightforward correspondence between the surface coordinate X and the magnetic field amplitude. In another or further embodiment, the amplitude of the magnetic field varies linearly, or according to another known function, over the sample 11s. This may further simplify mapping the magnetic field amplitudes to the corresponding coordinate X.

In one embodiment, a direction of the magnetic field B is aligned with a direction of the magnetic resonance sensors NV, e.g. an orientation of a crystal lattice with point defects forming the magnetic resonance sensors NV. For example, a direction of the electron spin of the colour center is aligned with the direction of the magnetic field. It will be noted that the direction of the magnetic (vector) field may be different than the direction of the magnetic (amplitude) gradient.

FIG 6A and 6B schematically illustrate a cross-section and perspective view of one embodiment of a sample cell 11.

In one embodiment, the sample cell 11 comprises a sample chamber for holding a sample 11s to be measured. Preferably, a wall of the sample chamber is formed by a sensor array 12 with a sensor interface. The sensor array 12 comprises a plurality of magnetic resonance sensors NV distributed along at least one surface coordinate X of the sensor interface. Typically, the sample cell 11 is configured to provide the sample 11s in contact with the sensor interface 12a.

In some embodiments, a separate or integrated magnet 13 is configured to apply a magnetic field gradient over the sample 11s such that the magnetic field in use varies over different regions of the sample 11s as a function of a respective position of each sample region along the surface coordinate X of the sensor interface.

In one embodiment, the sample 11s contacts the sensor interface over an extended two dimensional surface. Preferably, the sample cell or flow channel is flattened in a direction transverse to the sensor interface. As described herein, the magnetic field B is varied along a first dimension X. In some embodiments, signals of the magnetic resonance sensors NV are integrated over points along a second direction where the magnetic field B is constant.

In other or further embodiments, the sample 11s itself is varied along a second dimension Y, preferably transverse to the first dimension X. In one embodiment, the sample cell 11 comprise one or more flow channels F1,F2 to flow the sample 11s over the sensor interface of the sensor array 12. For example, the sample 11s flows in a direction Y transverse to the surface coordinate X along the magnetic field gradient. In another or further embodiment, magnetic resonances of a sample 11s in a flow channel F3 are measured both along the flow direction Y and the direction X of the magnetic gradient. For example, a chemical and/or biological reaction is measured along the flow direction Y.

In one embodiment, two or more flow channels F1,F2 with reaction components come together in a combined flow channel F3 to produce reaction products. In another or further embodiment, the sample 11s to be measured comprises the reaction products in the combined channel F3. It will be appreciated that this allows the progression of a reaction to be measured by instantaneous measurement of magnetic resonance spectra at different positions Y along the reaction channel F3. In some embodiments, a flow rate in the channel F3 is adapted to control the resolution of different reaction stages along the flow coordinate Y. For example by increasing the flow rate, different stages of the reaction may be further apart along the dimension Y of the flow.

In one embodiment, e.g. as illustrated in FIG 6B or otherwise, the sample 11s is held in sample cell formed between a magnet 13 and the sensor array 12. In another or further embodiment, the magnet 13 has a variable degree of magnetization along the surface coordinate X. This may provide a relatively compact arrangement. It can even be envisaged to apply light sensors (not shown) directly to the sensor array 12 for an even further compactification.

FIGs 7A-7C schematically illustrates another example for varying the sample along the second dimension. In one embodiment, a chemical or biological gradient G is formed onto the sensor interface 12a in one direction Y transverse to the surface coordinate X which will be along the magnetic field gradient. For example, a plasma gradient is applied to the surface of the material forming the sensor interface 12a. For example a first step 701 comprises implanting surface defects; a second step comprises annealing to form colour centers NV, and a third step comprises creating a chemical gradient e.g. using gradient plasma treatment.

FIGs 8A and 8B schematically illustrate an alternative embodiment similar to FIGs 1A and 1B, but without the physical sensor interface separating the (solid) array of sensors from the sample. Instead, in the embodiment shown, the plurality of magnetic resonance sensors 12s are distributed throughout the sample along a sample coordinate X. The magnetic field B varies over different regions S of the sample 11s as a function of a respective position of each sample region S along the sample coordinate X. The sensor signals Lu of the magnetic resonance sensors 12s are thus recorded as a function of the sample coordinate to determine the magnetic resonance spectrum M.

In one embodiment, the sample coordinate may be a surface coordinate along a surface of a (relatively thin) sample cell 11 holding the sample 11s. While the sensors 12s are distributed through the sample 11s to measure respective regions S thereof, the sample 11s is distinguished from the sensors, e.g. comprising a liquid or biological sample. For example, the sensors 12s may comprise magnetically sensitive particles such as nanocrystals with NV centers embedded throughout the sample 11s. In some embodiments, the sample 11s may comprise a suspension with NV nanocrystals.

While the present systems and methods have been described in particular detail with reference to specific exemplary embodiments thereof, it should also be appreciated that numerous modifications and alternative embodiments may be devised by those having ordinary skill in the art without departing from the scope of the present disclosure. For example, embodiments wherein devices or systems are disclosed to be arranged and/or constructed for performing a specified method or function inherently disclose the method or function as such and/or in combination with other disclosed embodiments of methods or systems. Furthermore, embodiments of methods are considered to inherently disclose their implementation in respective hardware, where possible, in combination with other disclosed embodiments of methods or systems. Furthermore, methods that can be embodied as program instructions, e.g. on a non-transient computer-readable storage medium, are considered inherently disclosed as such embodiment.

Finally, the above-discussion is intended to be merely illustrative of the present systems and/or methods and should not be construed as limiting the appended claims to any particular embodiment or group of embodiments. The specification and drawings are accordingly to be regarded in an illustrative manner and are not intended to limit the scope of the appended claims. In interpreting the appended claims, it should be understood that the word "comprising" does not exclude the presence of other elements or acts than those listed in a given claim; the word "a" or "an" preceding an element does not exclude the presence of a plurality of such elements; any reference signs in the claims do not limit their scope; several "means" may be represented by the same or different item(s) or implemented structure or function; any of the disclosed devices or portions thereof may be combined together or separated into further portions unless specifically stated otherwise. The mere fact that certain measures are recited in mutually different claims does not indicate that a combination of these measures cannot be used to advantage. In particular, all working combinations of the claims are considered inherently disclosed.

## Claims

1. A method for measuring a magnetic resonance spectrum (M) of a sample (11s), the method comprising
- providing the sample (11s) to be measured in proximity to a sensor array (12), the sensor array (12) comprising a plurality of magnetic resonance sensors (12s) distributed along a predefined coordinate (X) of the sensor array (12);
- applying a magnetic field gradient over the sample (11s), wherein the magnetic field (B) varies over different regions (S) of the sample (11s) as a function of a respective position of each sample region (S) along the coordinate (X); and
- recording, in the presence of the magnetic field gradient, sensor signals (Lu) of the magnetic resonance sensors (12s) as a function of the coordinate (X) to determine the magnetic resonance spectrum (M), the sensor signals acquired with the magnetic resonance sensors (12s) being dependent on nearby magnetic resonance of the sample and corresponding to respective parts of the magnetic resonance spectrum dependent on the coordinate (X).

2. The method according to claim 1, wherein
- the sample (11s) is provided in contact with a sensor interface (12a) forming a physical boundary of the sensor array (12), the sensor array (12) comprising the plurality of magnetic resonance sensors (12s) distributed along a surface coordinate (X) of the sensor interface (12a);
- the magnetic field (B) varies over different regions (S) of the sample (11s) as a function of a respective position of each sample region (S) along the surface coordinate (X) of the sensor interface (12a); and
- the sensor signals (Lu) of the magnetic resonance sensors (12s) are recorded as a function of the surface coordinate (X) to determine the magnetic resonance spectrum (M).

3. The method according to any of the preceding claims, wherein each respective sensor (12s) of the sensor array (12) is configured to provide a sensor signal (Lu) as a function of a coupling (C) depending on an energy matching (ΔE_{NV}=ΔE_{R}) between a magnetic resonance (NV₀₋₁) of a respective sensor (12s) and a magnetic resonance (R₂) of a respective sample region (S) of the sample (11s) at the coordinate (X).

4. The method according to any of the preceding claims, wherein the variation of the magnetic field (B) in the sample (11s) causes a corresponding variation of resonance energies (ΔE_{R1}, ΔE_{R2}, ΔE_{R13}) associated with one or more magnetic resonances (R₁,R₂,R₃) in the sample (11s) as a function of the respective position of each sample region (S) along the coordinate (X), wherein the sensor signals (Lu) are produced for each respective sample region (S) within range of a respective sensor (12s) at a specific coordinate (X₂) that has a coupling (C) with a corresponding magnetic resonance (NV₀₋₁) of the respective sensor (12s).

5. The method according to any of the preceding claims, wherein an amplitude or strength of the magnetic field (B) varies as a function of the coordinate (X), wherein the amplitude of the magnetic field (B) is determined as a function of the coordinate (X), wherein the magnetic resonance spectrum (M) of the sample (11s) is calculated based on the sensor signals (Lu) as a function of the coordinate (X) based on the correspondingly determined magnetic field, wherein amplitudes (M1,M2,M3) of the magnetic resonance spectrum (M) are calculated based on amplitudes (L1,L2,L3) of the measured sensor signals (Lu) for different positions (X1,X2,X3) along the coordinate (X) based on corresponding values (B1,B2,B3) of the magnetic field (B) at those positions.

6. The method according to any of the preceding claims, wherein a correspondence between one or more coordinates (X,Y) of the sensor array (12) and a corresponding effect of the magnetic field (B) at those coordinates is calibrated, e.g. using a reference sample.

7. The method according to claim 2 or any of claims 3-6 as dependent on claim 2, wherein the sensor signals (Lu) comprise light, wherein the magnetic resonance sensors (12s) comprise transducers producing the light as a function of a magnetic resonance in the nearby sample region (S), wherein an amount of light depends on a local coupling (C) of a respective sensor (12s) with its respective nearby sample region (S), wherein measurement of the sensor signals (Lu) comprises imaging light emitted from the sensor interface (12a) on an array of light sensors wherein the surface coordinate (X) of the sensor interface (12a) is projected onto different sensor element of the measurement device (16) extending along at least one measurement direction aligned with a projection of the surface coordinate (X).

8. The method according to claim 2 or any of claims 3-7 as dependent on claim 2, wherein the magnetic resonance sensors (12s) are pumped by a first light beam (Li) from an equilibrium state (sₑ) to an initial state (so), wherein the sensors decay back to an equilibrium state (sₑ) according to a relaxation time (T₁), wherein the sensors (12s) are given a predefined time (Δt) to couple or interact with a resonance of a respective sample regions (S) under the influence of the specific magnetic field (B) dependent on the position of the sample region (S) and a respective sensor along the surface coordinate (X), wherein the relaxation time (T₁) of the respective sensor (12s) is dependent on a coupling between the sensor and a respective sample region (S), and wherein a relaxation time (T₁) of the magnetic resonance sensors (12s) is measured to determine the magnetic resonance spectrum (M).

9. The method according to any of the preceding claims, wherein the sample (11s) extends over a two dimensional surface, wherein along a first dimension (X), the magnetic field (B) is varied, wherein signals of the magnetic resonance sensors (12s) are integrated over points along a second direction where the magnetic field (B) is constant.

10. The method according to any of the preceding claims, wherein the sample (11s) extends over a two dimensional surface, wherein along a first dimension (X), the magnetic field (B) is varied, wherein along a second dimension (Y), transverse to the first dimension (X), the sample (11s) itself is varied.

11. The method according to any of the preceding claims, wherein a sample cell (11) comprise one or more flow channels (F1,F2) to flow the sample (11s) over a sensor interface (12a) of the sensor array (12), wherein the sample (11s) flows in a direction (Y) transverse to the surface coordinate (X) along the magnetic field gradient.

12. The method according to claim 2 or any of claims 3-11 as dependent on claim 2, wherein a chemical and/or biological gradient (G) is formed onto the sensor array (12a) in one direction (Y) transverse to the surface coordinate (X) along the magnetic field gradient.

13. The method according to any of the preceding claims, wherein the sensors (12s) comprise colour centers (NV) with an electron-spin (mₛ) dependent luminescence behavior, wherein the electron-spin (mₛ) of the colour center (NV) is influenced by coupling (C) with magnetic resonances of the nearby sample region (S).

14. A system (100) for measuring a magnetic resonance spectrum (M) of a sample (11s), the system comprising
- a sensor array (12) comprising a plurality of magnetic resonance sensors (12s) distributed along a coordinate (X);
- a sample cell (11) configured to provide the sample (11s) to be measured in proximity to the sensor array (12) ;
- a magnet (13) configured to apply a magnetic field gradient over the sample (11s), wherein the magnetic field (B) in use varies over different regions (S) of the sample (11s) as a function of a respective position of each sample region (S) along the coordinate (X); and
- a measurement device (16) configured to record, in the presence of the magnetic field gradient, sensor signals (Lu) of the magnetic resonance sensors (12s) as a function of the coordinate (X) to determine the magnetic resonance spectrum (M), the sensor signals recorded with the magnetic resonance sensors (12s) being dependent on nearby magnetic resonance of the sample and corresponding to respective parts of the magnetic resonance spectrum dependent on the coordinate (X).

## Patentansprüche

1. Verfahren zur Messung eines magnetischen Resonanzspektrums (M) einer Probe (11s), wobei das Verfahren umfasst
- Bereitstellen der zu messenden Probe (11s) in der Nähe eines Sensorarrays (12), wobei das Sensorarray (12) mehrere Magnetresonanzsensoren (12s) umfasst, die entlang einer vordefinierten Koordinate (X) des Sensorarrays (12) verteilt sind;
- Anlegen eines Magnetfeldgradienten über die Probe (11s), wobei das Magnetfeld (B) über verschiedene Bereiche (S) der Probe (11s) entsprechend einer jeweiligen Position jedes Probenbereichs (S) entlang der Koordinate (X) variiert; und
- Aufnehmen von Sensorsignalen (Lu) der Magnetresonanzsensoren (12s) in Anwesenheit des Magnetfeldgradienten als Funktion der Koordinate (X), um das magnetische Resonanzspektrum (M) zu bestimmen, wobei die mit den Magnetresonanzsensoren (12s) erfassten Sensorsignale von der nahen magnetischen Resonanz der Probe abhängen und den jeweiligen Teilen des magnetischen Resonanzspektrums in Abhängigkeit von der Koordinate (X) entsprechen.

2. Verfahren nach Anspruch 1, wobei
- die Probe (11s) in Kontakt mit einer Sensorschnittstelle (12a) vorgesehen ist, die eine physikalische Grenze des Sensorarrays (12) bildet, wobei das Sensorarray (12) mehrere Magnetresonanzsensoren (12s) umfasst, die entlang einer Oberflächenkoordinate (X) der Sensorschnittstelle (12a) verteilt sind;
- das Magnetfeld (B) über verschiedene Bereiche (S) der Probe (11s) entsprechend einer jeweiligen Position jedes Probenbereichs (S) entlang der Oberflächenkoordinate (X) der Sensorschnittstelle (12a) variiert; und
- die Sensorsignale (Lu) der Magnetresonanzsensoren (12s) entsprechend der Oberflächenkoordinate (X) aufgezeichnet werden, um das magnetische Resonanzspektrum (M) zu ermitteln.

3. Verfahren nach einem der vorhergehenden Ansprüche, wobei jeder entsprechende Sensor (12s) des Sensorarrays (12) so ausgelegt ist, dass er ein Sensorsignal (Lu) entsprechend einer Kopplung (C) in Abhängigkeit von einer Energieanpassung (ΔE_{NV}=4E_{R}) zwischen einer magnetischen Resonanz (NV₀₋₁) eines entsprechenden Sensors (12s) und einer magnetischen Resonanz (R₂) eines entsprechenden Probenbereichs (S) der Probe (11s) an der Koordinate (X) bereitstellt.

4. Verfahren nach einem der vorhergehenden Ansprüche, wobei die Variation des Magnetfeldes (B) in der Probe (11s) eine entsprechende Variation von Resonanzenergien (ΔE_{R1}, ΔE_{R2}, ΔE_{R13}), die einer oder mehreren magnetischen Resonanzen (R₁,R₂,R₃) in der Probe (11s) zugeordnet sind, entsprechend der jeweiligen Position jedes Probenbereichs (S) entlang der Koordinate (X) bewirkt, wobei die Sensorsignale (Lu) für jeden jeweiligen Probenbereich (S) im Bereich eines jeweiligen Sensors (12s) an einer bestimmten Koordinate (X₂) erzeugt werden, der eine Kopplung (C) mit einer entsprechenden magnetischen Resonanz (NV₀₋₁) des jeweiligen Sensors (12s) aufweist.

5. Verfahren nach einem der vorhergehenden Ansprüche, wobei eine Amplitude oder Stärke des Magnetfeldes (B) entsprechend der Koordinate (X) variiert, wobei die Amplitude des Magnetfeldes (B) entsprechend der Koordinate (X) bestimmt wird, wobei der magnetische Resonanzspektrum (M) der Probe (11s) basierend auf den Sensorsignalen (Lu) entsprechend der Koordinate (X) basierend auf dem entsprechend bestimmten Magnetfeld berechnet wird, wobei Amplituden (M1,M2,M3) des magnetischen Resonanzspektrums (M) basierend auf Amplituden (L1,L2,L3) der gemessenen Sensorsignale (Lu) für verschiedene Positionen (X1,X2,X3) entlang der Koordinate (X) basierend auf entsprechenden Werten (B1,B2,B3) des Magnetfeldes (B) an diesen Positionen berechnet werden.

6. Verfahren nach einem der vorhergehenden Ansprüche, wobei eine Übereinstimmung zwischen einer oder mehreren Koordinaten (X,Y) des Sensorarrays (12) und einer entsprechenden Wirkung des Magnetfelds (B) an diesen Koordinaten kalibriert wird, z. B. unter Verwendung einer Referenzprobe.

7. Verfahren nach Anspruch 2 oder einem der von Anspruch 2 abhängigen Ansprüche 3 bis 6, wobei die Sensorsignale (Lu) Licht umfassen, wobei die Magnetresonanzsensoren (12s) Wandler umfassen, die das Licht entsprechend einer magnetischen Resonanz in dem nahen Probenbereich (S) erzeugen, wobei eine Lichtmenge von einer lokalen Kopplung (C) eines jeweiligen Sensors (12s) mit seinem jeweiligen nahen Probenbereich (S) abhängt, wobei die Messung der Sensorsignale (Lu) das Abbilden von Licht, das von der Sensorschnittstelle (12a) emittiert wird, auf einem Array von Lichtsensoren umfasst, wobei die Oberflächenkoordinate (X) der Sensorschnittstelle (12a) auf verschiedene Sensorelemente der Messvorrichtung (16) projiziert wird, die sich entlang wenigstens einer Messrichtung erstrecken, die mit einer Projektion der Oberflächenkoordinate (X) ausgerichtet ist.

8. Verfahren nach Anspruch 2 oder einem der von Anspruch 2 abhängigen Ansprüche 3 bis 7, wobei die Magnetresonanzsensoren (12s) durch einen ersten Lichtstrahl (Li) aus einem Gleichgewichtszustand (sₑ) in einen Ausgangszustand (so) gepumpt werden, wobei die Sensoren entsprechend einer Relaxationszeit (T₁) wieder in einen Gleichgewichtszustand (sₑ) zurückkehren, wobei den Sensoren (12s) eine vordefinierte Zeit (Δt) gegeben wird, um mit einer Resonanz eines jeweiligen Probenbereichs (S) unter dem Einfluss des spezifischen Magnetfelds (B) abhängig von der Position des Probenbereichs (S) und eines jeweiligen Sensors entlang der Oberflächenkoordinate (X) zu koppeln oder zu interagieren, wobei die Relaxationszeit (T₁) des jeweiligen Sensors (12s) von einer Kopplung zwischen dem Sensor und einem jeweiligen Probenbereich (S) abhängig ist, und wobei eine Relaxationszeit (T₁) der Magnetresonanzsensoren (12s) gemessen wird, um das magnetische Resonanzspektrum (M) zu bestimmen.

9. Verfahren nach einem der vorhergehenden Ansprüche, wobei sich die Probe (11s) über eine zweidimensionale Fläche erstreckt, wobei entlang einer ersten Dimension (X) das Magnetfeld (B) variiert, wobei Signale der Magnetresonanzsensoren (12s) über Punkte entlang einer zweiten Richtung integriert werden, wo das Magnetfeld (B) konstant ist.

10. Verfahren nach einem der vorhergehenden Ansprüche, wobei sich die Probe (11s) über eine zweidimensionale Fläche erstreckt, wobei entlang einer ersten Dimension (X) das Magnetfeld (B) variiert, wobei entlang einer zweiten Dimension (Y), quer zur ersten Dimension (X), die Probe (11s) selbst variiert.

11. Verfahren nach einem der vorhergehenden Ansprüche, wobei eine Probenzelle (11) einen oder mehrere Strömungskanäle (F1,F2) umfasst, um die Probe (11s) über eine Sensorschnittstelle (12a) des Sensorarrays (12) strömen zu lassen, wobei die Probe (11s) in einer Richtung (Y) quer zur Oberflächenkoordinate (X) entlang des Magnetfeldgradienten strömt.

12. Verfahren nach Anspruch 2 oder einem der Ansprüche 3 bis 11 in Abhängigkeit von Anspruch 2, wobei auf dem Sensorarray (12 a) in einer Richtung (Y) quer zur Oberflächenkoordinate (X) entlang des Magnetfeldgradienten ein chemischer und/oder biologischer Gradient (G) ausgebildet wird.

13. Verfahren nach einem der vorhergehenden Ansprüche, wobei die Sensoren (12s) Farbzentren (NV) mit einem von Elektronenspin (mₛ) abhängigen Lumineszenzverhalten umfassen, wobei der Elektronenspin (mₛ) des Farbzentrums (NV) durch Kopplung (C) mit magnetischen Resonanzen des nahen Probenbereichs (S) beeinflusst wird.

14. System (100) zum Messen eines magnetischen Resonanzspektrums (M) einer Probe (11s), wobei das System umfasst
- ein Sensorarray (12) mit mehreren Magnetresonanzsensoren (12s), die entlang einer Koordinate (X) verteilt sind;
- eine Probenzelle (11), die so ausgelegt ist, dass sie die zu messende Probe (11s) in der Nähe des Sensorarrays (12) bereitstellt;
- einen Magneten (13), der so ausgelegt ist, dass er einen Magnetfeldgradienten über der Probe (11s) anlegt, wobei das Magnetfeld (B) im Gebrauch über verschiedenen Bereichen (S) der Probe (11s) entsprechend einer jeweiligen Position jedes Probenbereichs (S) entlang der Koordinate (X) variiert; und
- eine Messvorrichtung (16), die so ausgelegt ist, dass sie in Anwesenheit des Magnetfeldgradienten Sensorsignale (Lu) der Magnetresonanzsensoren (12s) als Funktion der Koordinate (X) aufzeichnet, um das magnetische Resonanzspektrum (M) zu bestimmen, wobei die mit den Magnetresonanzsensoren (12s) aufgezeichneten Sensorsignale von der nahen magnetischen Resonanz der Probe abhängen und den jeweiligen Teilen des magnetischen Resonanzspektrums in Abhängigkeit von der Koordinate (X) entsprechen.

## Revendications

1. Procédé de mesure d'un spectre de résonance magnétique (M) d'un échantillon (11s), le procédé comprenant :
- la fourniture de l'échantillon (11s) à mesurer à proximité d'un réseau de capteurs (12), le réseau de capteurs (12) comprenant une pluralité de capteurs de résonance magnétique (12s) répartis le long d'une coordonnée prédéfinie (X) du réseau de capteurs (12) ;
- l'application d'un gradient de champ magnétique sur l'échantillon (11s), dans lequel le champ magnétique (B) varie sur différentes régions (S) de l'échantillon (11s) en fonction d'une position respective de chaque région d'échantillon (S) le long de la coordonnée (X) ; et
- l'enregistrement, en présence du gradient de champ magnétique, de signaux de capteur (Lu) des capteurs de résonance magnétique (12s) en fonction de la coordonnée (X) pour déterminer le spectre de résonance magnétique (M), les signaux de capteurs acquis avec les capteurs de résonance magnétique (12s) dépendant de la résonance magnétique avoisinante de l'échantillon et correspondant à des parties respectives du spectre de résonance magnétique dépendant de la coordonnée (X).

2. Procédé selon la revendication 1, dans lequel
- l'échantillon (11s) est mis en contact avec une interface de capteur (12a) formant une limite physique du réseau de capteurs (12), le réseau de capteurs (12) comprenant la pluralité de capteurs de résonance magnétique (12s) répartis le long d'une coordonnée de surface (X) de l'interface de capteur (12a) ;
- le champ magnétique (B) varie sur différentes régions (S) de l'échantillon (11s) en fonction d'une position respective de chaque région d'échantillon (S) le long de la coordonnée de surface (X) de l'interface de capteur (12a) ; et
- les signaux de capteur (Lu) des capteurs de résonance magnétique (12s) sont enregistrés en fonction de la coordonnée de surface (X) afin de déterminer le spectre de résonance magnétique (M).

3. Procédé selon l'une quelconque des revendications précédentes, dans lequel chaque capteur respectif (12s) du réseau de capteurs (12) est configuré pour fournir un signal de capteur (Lu) en fonction d'un couplage (C) dépendant d'un appariement d'énergie (ΔE_{NV} = ΔE_{R}) entre une résonance magnétique (NV₀₋₁) d'un capteur respectif (12s) et une résonance magnétique (R₂) d'une région d'échantillon respective (S) de l'échantillon (11s) à la coordonnée (X).

4. Procédé selon l'une quelconque des revendications précédentes, dans lequel la variation du champ magnétique (B) dans l'échantillon (11s) provoque une variation correspondante d'énergies de résonance (ΔE_{R1}, ΔE_{R2}, ΔE_{R13}) associées à une ou plusieurs résonances magnétiques (R₁, R₂, R₃) dans l'échantillon (11s) en fonction de la position respective de chaque région d'échantillon (S) le long de la coordonnée (X), dans lequel les signaux de capteur (Lu) sont produits pour chaque région d'échantillon respective (S) dans une plage d'un capteur respectif (12s) à une coordonnée spécifique (X₂) qui présente un couplage (C) avec une résonance magnétique correspondante (NV₀₋₁) du capteur respectif (12s).

5. Procédé selon l'une quelconque des revendications précédentes, dans lequel une amplitude ou une force du champ magnétique (B) varie en fonction de la coordonnée (X), dans lequel l'amplitude du champ magnétique (B) est déterminée en fonction de la coordonnée (X), dans lequel le spectre de résonance magnétique (M) de l'échantillon (11s) est calculé sur la base des signaux de capteur (Lu) en fonction de la coordonnée (X), sur la base du champ magnétique déterminé de manière correspondante, dans lequel des amplitudes (M1, M2, M3) du spectre de résonance magnétique (M) sont calculées sur la base d'amplitudes (L1, L2, L3) des signaux de capteur mesurés (Lu) pour différentes positions (X1, X2, X3) le long de la coordonnée (X) sur la base de valeurs correspondantes (B1, B2, B3) du champ magnétique (B) dans ces positions.

6. Procédé selon l'une quelconque des revendications précédentes, dans lequel une correspondance entre une ou plusieurs coordonnées (X, Y) du réseau de capteurs (12) et un effet correspondant du champ magnétique (B) à ces coordonnées est calibré, par exemple en utilisant un échantillon de référence.

7. Procédé selon la revendication 2 ou l'une quelconque des revendications 3 à 6, dépendant de la revendication 2, dans lequel les signaux de capteur (Lu) comprennent la lumière, dans lequel les capteurs de résonance magnétique (12s) comprennent des transducteurs produisant la lumière en fonction d'une résonance magnétique dans la région d'échantillon avoisinante (S), dans lequel une quantité de lumière dépend d'un couplage local (C) d'un capteur respectif (12s) avec sa région d'échantillon avoisinante respective (S), dans lequel une mesure des signaux de capteur (Lu) comprend la lumière d'imagerie émise par l'interface de capteur (12a) sur un réseau de capteurs de lumière dans lequel la coordonnée de surface (X) de l'interface de capteur (12a) est projetée sur un élément de capteur différent du dispositif de mesure (16) s'étendant le long d'au moins une direction de mesure alignée avec une projection de la coordonnée de surface (X).

8. Procédé selon la revendication 2 ou l'une quelconque des revendications 3 à 7, dépendant de la revendication 2, dans lequel les capteurs de résonance magnétique (12s) sont pompés par un premier faisceau lumineux (Li) d'un état d'équilibre (sₑ) à un état initial (s₀), dans lequel les capteurs reviennent à un état d'équilibre (sₑ) selon un temps de relaxation (T₁), dans lequel les capteurs (12s) se voient attribuer un temps prédéfini (Δt) pour se coupler ou interagir avec une résonance de régions d'échantillon respectives (S) sous l'influence du champ magnétique spécifique (B) en fonction de la position de la région d'échantillon (S) et d'un capteur respectif le long de la coordonnée de surface (X), dans lequel le temps de relaxation (T₁) du capteur respectif (12s) dépend d'un couplage entre le capteur et une région d'échantillon respective (S) et dans lequel un temps de relaxation (T₁) des capteurs de résonance magnétique (12s) est mesuré pour déterminer le spectre de résonance magnétique (M).

9. Procédé selon l'une quelconque des revendications précédentes, dans lequel l'échantillon (11s) s'étend sur une surface en deux dimensions, dans lequel, le long d'une première dimension (X), le champ magnétique (B) est modifié, dans lequel des signaux des capteurs de résonance magnétique (12s) sont intégrés sur des points le long d'une seconde direction où le champ magnétique (B) est constant.

10. Procédé selon l'une quelconque des revendications précédentes, dans lequel l'échantillon (11s) s'étend sur une surface en deux dimensions, dans lequel le long d'une première dimension (X), le champ magnétique (B) est modifié, dans lequel le long d'une seconde dimension (Y), transversale à la première dimension (X), l'échantillon (11s) lui-même est modifié.

11. Procédé selon l'une quelconque des revendications précédentes, dans lequel une cellule d'échantillon (11) comprend un ou plusieurs canaux d'écoulement (F1, F2) pour permettre l'écoulement de l'échantillon (11s) sur une interface de capteur (12a) du réseau de capteurs (12), dans lequel l'échantillon (11s) s'écoule dans une direction (Y) transversale à la coordonnée de surface (X) le long d'un gradient de champ magnétique.

12. Procédé selon la revendication 2 ou l'une quelconque des revendications 3 à 11, dépendant de la revendication 2, dans lequel un gradient chimique et/ou biologique (G) est formé sur le réseau de capteurs (12a) dans une direction (Y) transversale à la coordonnée de surface (X) le long du gradient de champ magnétique.

13. Procédé selon l'une quelconque des revendications précédentes, dans lequel les capteurs (12s) comprennent des centres de couleur (NV) avec un comportement de luminescence dépendant d'une rotation d'électron (mₛ), dans lequel la rotation d'électron (mₛ) du centre de couleur (NV) est influencée par le couplage (C) avec des résonances magnétiques de la région d'échantillon avoisinante (S).

14. Système (100) pour mesurer un spectre de résonance magnétique (M) d'un échantillon (11s), le système comprenant :
- un réseau de capteurs (12) comprenant une pluralité de capteurs de résonance magnétique (12s) répartis le long d'une coordonnée (X) ;
- une cellule d'échantillon (11) configurée pour fournir l'échantillon (11s) à mesurer à proximité du réseau de capteurs (12) ;
- un aimant (13) configuré pour appliquer un gradient de champ magnétique sur l'échantillon (11s), dans lequel le champ magnétique (B) en cours d'utilisation varie sur différentes régions (S) de l'échantillon (11s) en fonction d'une position respective de chaque région d'échantillon (S) le long de la coordonnée (X) ; et
- un dispositif de mesure (16) configuré pour enregistrer, en présence du gradient de champ magnétique, des signaux de capteur (Lu) des capteurs de résonance magnétique (12s) en fonction de la coordonnée (X) afin de déterminer le spectre de résonance magnétique (M), les signaux de capteur enregistrés avec les capteurs de résonance magnétique (12s) dépendant de la résonance magnétique avoisinante de l'échantillon et correspondant à des parties respectives du spectre de résonance magnétique dépendant de la coordonnée (X).
